(19) Europäisches Patentamt
European Patent Office
Office européen des brevets

(11) **EP 3 468 020 B1**

(12) **EUROPEAN PATENT SPECIFICATION**

(45) Date of publication and mention
of the grant of the patent:
**28.04.2021 Bulletin 2021/17**

(51) Int Cl.:
***H02M 1/44*** *(2007.01)*     *H02M 1/14* *(2006.01)*
***H02M 3/156*** *(2006.01)*

(21) Application number: **16904045.8**

(22) Date of filing: **02.06.2016**

(86) International application number:
**PCT/JP2016/066399**

(87) International publication number:
**WO 2017/208420 (07.12.2017 Gazette 2017/49)**

(54) **POWER CONVERSION DEVICE**

STROMWANDLUNGSVORRICHTUNG

DISPOSITIF DE CONVERSION DE PUISSANCE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**10.04.2019 Bulletin 2019/15**

(73) Proprietor: **Nissan Motor Co., Ltd.
Yokohama-shi, Kanagawa 221-0023 (JP)**

(72) Inventors:
• **SHIN, Kentaro
Atsugi-shi, Kanagawa 243-0123 (JP)**
• **YAMAGAMI, Shigeharu
Atsugi-shi, Kanagawa 243-0123 (JP)**

(74) Representative: **Hoefer & Partner Patentanwälte
mbB
Pilgersheimer Straße 20
81543 München (DE)**

(56) References cited:
**EP-A2- 1 610 450**     **WO-A1-03/105328**
**JP-A- H10 127 048**     **JP-A- S62 131 757**
**JP-A- 2004 350 361**     **JP-A- 2007 507 200**
**JP-A- 2013 240 168**     **JP-A- 2014 087 107**
**JP-A- 2014 220 889**     **US-A1- 2009 290 392**
**US-A1- 2015 303 788**

**Description**

TECHNICAL FIELD

The present invention relates to a power conversion device that converts power output from an alternating-current power supply or a direct-current power supply to desired direct-current power.

BACKGROUND ART

Conventionally, a power conversion device is used for charging a low-voltage battery from a high-voltage battery, in an electric car, a hybrid vehicle, or the like. A switch is mounted inside the power conversion device, which is formed by a power semiconductor element of a discrete package or a modularized power semiconductor element (hereinafter, "power module"). The power module switches on/off of the switch by a signal provided from a control circuit to convert a voltage.

When a switching element is switched on and off, switching noise is generated in the power module and propagates to the power-supply side and the load side. Therefore, in a case where power is supplied from a commercial power supply installed in a standard home to a power conversion device mounted on a vehicle, for example, noise may propagate to an electric system on the home side.

Patent Literature 1 discloses dividing a choke coil into two to be inserted respectively into both a power line and a ground line in order to remove noise, and also discloses removing noise by providing a filter at each of a preceding stage and a subsequent stage of the choke coil.

From EP 1 610 450 A2, a power converter system for a railway vehicle which is adapted both for a track using a commercial power supply and a track circuit using a high-frequency alternating-current power supply is known, in which the number of filter circuits and the weight of the filter circuits are not increased.

CITATION LIST

PATENT LITERATURE

Patent Literature 1: Japanese Patent Laid-Open Publication No. H11-341787

SUMMARY OF INVENTION

However, a circuit disclosed in Patent Literature 1 has a problem of increase of device scale.

The present invention has been made in view of such conventional problems. It is an object of the present invention to provide a power conversion device that can reduce noise generated by switching without increasing device scale.

The solution of this object is achieved by the features of the independent claim. The dependent claims contain advantageous embodiments of the present invention.

ADVANTAGEOUS EFFECTS OF INVENTION

According to an aspect of the present invention, it is possible to reduce noise generated by switching without increasing device scale.

BRIEF DESCRIPTION OF DRAWINGS

[Fig. 1] Fig. 1 is a circuit diagram illustrating a configuration of a power conversion device and peripheral devices thereof according to a first embodiment of the present invention.
[Fig. 2] Fig. 2 is a circuit diagram illustrating a configuration of a reactor and an impedance circuit of the power conversion device according to the first embodiment of the present invention.
[Fig. 3] Fig. 3 is a graph representing a relation between a frequency and an impedance in a case where the power conversion device according to the first embodiment of the present invention is applied, and a case where the power conversion device is not applied.
[Fig. 4] Fig. 4 is a graph representing a change of noise current in a case where the power conversion device according to the first embodiment of the present invention is applied, and a case where the power conversion device is not applied.

[Fig. 5] Fig. 5 is a graph representing a relation between a frequency and a noise level in a case where the power conversion device according to the first embodiment of the present invention is applied, and a case where the power conversion device is not applied.

[Fig. 6] Fig. 6 is a circuit diagram illustrating a configuration of a power conversion device and peripheral devices thereof according to a second embodiment of the present invention.

[Fig. 7] Fig. 7 is a graph representing cutoff characteristics of a filter circuit used in the power conversion device according to the second embodiment of the present invention.

[Fig. 8] Fig. 8 is a graph representing cutoff characteristics in a case where a filter circuit is affected by an inductance or an electrostatic capacitance.

[Fig. 9] Fig. 9 is a circuit diagram illustrating a configuration of a power conversion device and peripheral devices thereof according to a third embodiment of the present invention.

[Fig. 10] Fig. 10 is a diagram illustrating a reactor and an impedance circuit of a power conversion device according to a fourth embodiment of the present invention.

[Fig. 11] Fig. 11 is a graph representing a relation between a frequency and an impedance in the power conversion device according to the fourth embodiment of the present invention.

[Fig. 12] Fig. 12 is a diagram illustrating a reactor and an impedance circuit of a power conversion device according to a fifth embodiment of the present invention.

[Fig. 13] Fig. 13 is a diagram illustrating a reactor and an impedance circuit of a power conversion device according to a sixth embodiment of the present invention.

[Fig. 14] Fig. 14 is an equivalent circuit diagram of the impedance circuit and the reactor illustrated in Fig. 13.

[Fig. 15] Fig. 15 is a diagram illustrating a reactor and an impedance circuit of a power conversion device according to a first modification of the sixth embodiment of the present invention.

[Fig. 16] Fig. 16 is a diagram illustrating a reactor and an impedance circuit of a power conversion device according to a second modification of the sixth embodiment of the present invention.

[Fig. 17] Fig. 17 is a diagram illustrating a reactor and an impedance circuit of a power conversion device according to a seventh embodiment of the present invention.

[Fig. 18] Fig. 18 is an equivalent circuit diagram of the impedance circuit and the reactor illustrated in Fig. 17.

[Fig. 19] Fig. 19 is a circuit diagram illustrating a configuration of the power conversion device and peripheral devices thereof according to the embodiments of the present invention, while illustrating an example of including a rectifier circuit.

[Fig. 20] Fig. 20 is a circuit diagram illustrating a configuration of the power conversion device and peripheral devices thereof according to the embodiments of the present invention, while illustrating an example of including a bridge power module and a rectifier circuit.

DESCRIPTION OF EMBODIMENTS

Embodiments of the present invention are described below with reference to the accompanying drawings.

[Descriptions of first embodiment]

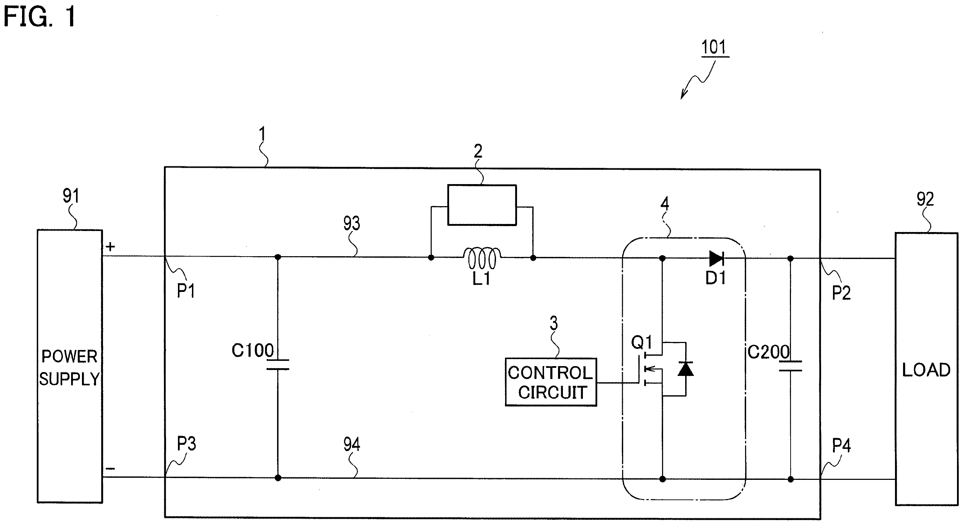

Fig. 1 is a circuit diagram illustrating a configuration of a power conversion device and peripheral devices thereof according to a first embodiment of the present invention. As illustrated in Fig. 1, a power conversion device 101 according to the present embodiment is entirely covered by a housing 1 made of metal, such as iron or aluminum. The input side of the power conversion device 101 is connected to a power supply 91 that outputs a direct current via a first power feed bus 93 and a second power feed bus 94, and the output side thereof is connected to a load 92. Therefore, it is possible to convert a voltage supplied from the power supply 91 into a desired voltage and supply the converted voltage to the load 92. The power supply 91 is a commercial power supply or a battery installed in a standard home, for example. The load 92 is a battery mounted on an electric car or a hybrid vehicle, for example.

A positive terminal of the power supply 91 is connected to the first power feed bus 93, and a negative terminal thereof is connected to the second power feed bus 94. A reactor L1 is connected to the first power feed bus 93. Further, a power module 4 including a switching element Q1 and a diode D1 is connected between the first power feed bus 93 and the second power feed bus 94 at a subsequent stage of the reactor L1.

The switching element Q1 is a semiconductor switch such as a MOSFET or an IGBT. A control input of the switching element Q1 (for example, a gate of a MOSFET) is connected to a control circuit 3 that controls on/off of the switching element Q1. By switching on/off of the switching element Q1 under control by the control circuit 3 to control a duty ratio, a direct current supplied from the power supply 91 is converted to a direct current with a different voltage to be supplied to the load 92.

The reactor L1 is a toroidal winding coil, for example. Further, smoothing capacitors C100 and C200 are provided at a preceding stage and a subsequent stage of the power module 4, respectively.

An impedance circuit 2 is provided in parallel with respect to the reactor L1. In the present embodiment, an impedance caused by the reactor L1 in a high-frequency band is reduced by providing the impedance circuit 2, and noise propagation to the metal housing 1 is prevented. More specifically, noise generated from the first power feed bus 93 and noise generated from the second power feed bus 94 are canceled out by making an impedance between points P1 and P2 of the first power feed bus 93 and an impedance between points P3 and P4 of the second power feed bus 94 closer to each other, so that high-frequency noise propagating to the metal housing 1 is reduced. To "make impedances closer to each other" is a concept that includes complete match of impedances.

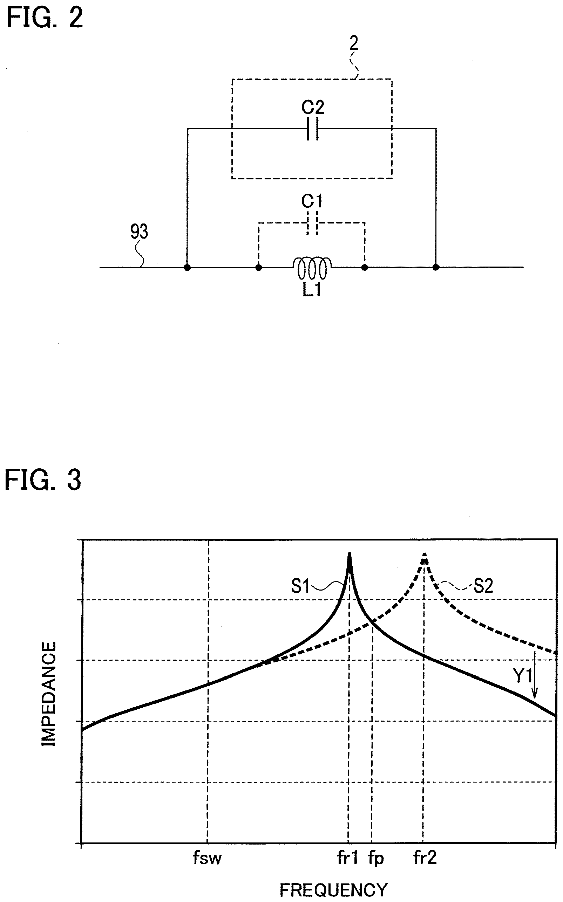

Fig. 2 is a circuit diagram illustrating a detailed configuration of the reactor L1 and the impedance circuit 2 illustrated in Fig. 1. As illustrated in Fig. 2, the reactor L1 has a parasitic capacitance C1. The impedance circuit 2, connected in parallel with respect to the reactor L1, includes a capacitance element C2. In the following descriptions, an element and a numerical value of that element are denoted by the same sign. For example, an inductance of the reactor L1 is L1, and an electrostatic capacitance of the capacitance element C2 is C2.

The electrostatic capacitance of the capacitance element C2 is set to be larger than the parasitic capacitance C1. That is, C2>C1. Therefore, assuming that an electrostatic capacitance connected in parallel with respect to the reactor L1 by providing the capacitance element C2 is an impedance Z1, the impedance Z1 can be expressed by the following expression (1).

$$Z1 = 1/\{j \cdot \omega \cdot (C1+C2)\} \qquad \cdots (1).$$

An impedance Z2 in a case where the capacitance element C2 is not provided can be expressed by the following expression (2).

$$Z2 = 1/(j \cdot \omega \cdot C1) \qquad \cdots (2).$$

It is then understood from the expressions (1) and (2) that Z1<Z2, and it is possible to reduce an impedance of the first power feed bus 93 by providing the capacitance element C2 with a larger electrostatic capacitance than the parasitic capacitance C1.

Fig. 3 is a graph representing a change of impedance of the reactor L1 and the impedance circuit 2 illustrated in Fig. 2. In Fig. 3, the horizontal axis represents a frequency and the vertical axis represents an impedance. A curve S1 illustrated with a solid line represents characteristics in a case where the capacitance element C2 is provided, and a curve S2 illustrated with a dotted line represents characteristics in a case where the capacitance element C2 is not provided.

A frequency fr1 is a resonance frequency (a first resonance frequency) in a case where the capacitance element C2 is provided, and a frequency fr2 is a resonance frequency in a case where the capacitance element C2 is not provided. The frequencies fr1 and fr2 can be expressed by the following expression s (3) and (4), respectively.

[Equation 1]

$$fr1 = \frac{1}{2\pi\sqrt{L1 \cdot (C1+C2)}} \qquad \cdots (3)$$

$$fr2 = \frac{1}{2\pi\sqrt{L1 \cdot C1}} \qquad \cdots (4)$$

Further, a frequency fsw illustrated in Fig. 3 is a switching frequency of the switching element Q1 illustrated in Fig. 1. As is understood from Fig. 3, the first resonance frequency fr1 is set to be higher than the frequency fsw. Therefore, in Fig. 3, the curve S1 is smaller in impedance than the curve S2 in a frequency band higher than a frequency fp of an intersection of the curve S1 and the curve S2. Accordingly, in this frequency band, the impedance of the first power feed bus 93 illustrated in Fig. 1 can be made closer to the impedance of the second power feed bus 94. As a result, it is possible to cancel out noise generated from the first power feed bus 93 and noise generated from the second power feed bus 94, so that an influence of noise can be reduced.

Further, the parasitic capacitance C1 of the reactor L1 varies by a switching frequency of the switching element Q1, the number of turns of the reactor L1, and a configuration of windings. In a case where the parasitic capacitance C1 is several pF, an impedance in a high-frequency band can be lowered by providing the capacitance element C2 with an electrostatic capacitance of several hundreds of pF, as illustrated with an arrow Y1 in Fig. 3.

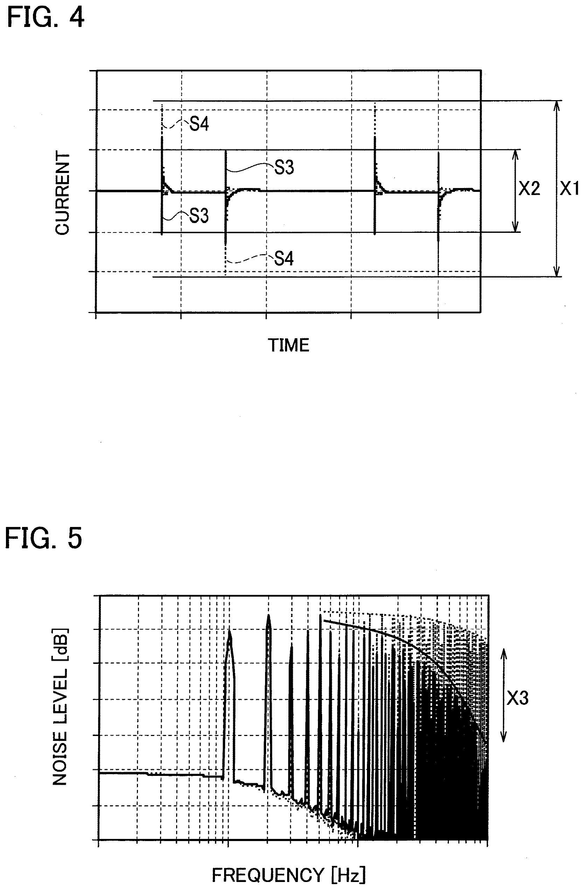

Fig. 4 is a graph representing a waveform of a current that flows through the metal housing 1. The horizontal axis in Fig. 4 represents a time, and represents a time at which the switching element Q1 within the power module 4 switches on and off twice. The vertical axis represents a value of current that flows through the metal housing 1. A curve S3 illustrated with a solid line represents characteristics in a case where the impedance circuit 2 is provided, and a curve S4 illustrated with a dotted line represents characteristics in a case where the impedance circuit 2 is not provided.

As illustrated in Fig. 4, in a case where the impedance circuit 2 is not provided, the current value varies in a range denoted by a sign X1. Meanwhile, in a case where the impedance circuit 2 is provided, the current value varies in a range denoted by a sign X2. Therefore, it is understood that a peak value of a noise current flowing through the metal housing 1 is reduced by providing the impedance circuit 2.

Fig. 5 illustrates a change of noise level when the current waveform illustrated in Fig. 4 is subjected to frequency analysis, in which the horizontal axis represents a frequency and the vertical axis represents a noise level. A solid line represents a current waveform in a case where the impedance circuit 2 is provided, and a broken line represents characteristics in a case where the impedance circuit 2 is not provided. As is understood from a characteristic curve in Fig. 5, the level of noise generated in the metal housing 1 is reduced in a high-frequency band by providing the impedance circuit 2. Specifically, noise is reduced by the amount denoted by a sign X3.

In this manner, in the power conversion device 101 according to the first embodiment, the impedance circuit 2 is provided in parallel with respect to the reactor L1. Therefore, an impedance caused by the reactor L1 can be reduced, so that an impedance of the first power feed bus 93 can be reduced. Accordingly, the impedance of the first power feed bus 93 can be made closer to an impedance of the second power feed bus 94. As a result, it is possible to cancel out a noise current generated by switching of the switching element Q1 and to reduce high-frequency noise generated in the metal housing 1.

Further, by configuring the impedance circuit 2 to include the capacitance element C2, an inductance of the reactor L1 can be easily canceled out. Therefore, it is possible to cancel out a noise current generated by switching of the switching element Q1 and to reduce high-frequency noise generated in the metal housing 1.

Furthermore, by setting an electrostatic capacitance of the capacitance element C2 of the impedance circuit 2 to be larger than the parasitic capacitance C1 of the reactor L1, the first resonance frequency fr1 can be set to be lower than the frequency fr2, as illustrated in Fig. 3. Therefore, it is possible to reduce the impedance caused by the reactor L1 and to make the impedance of the first power feed bus 93 closer to the impedance of the second power feed bus 94 by a simpler method.

In addition, as illustrated in Fig. 3, by setting the first resonance frequency fr1 to be larger than the switching frequency fsw of the switching element Q1, it is possible to reduce a high-frequency impedance caused by the reactor L1 without being influenced by a switching and driving operation in power conversion. Accordingly, it is possible to surely reduce high-frequency noise.

[Descriptions of second embodiment]

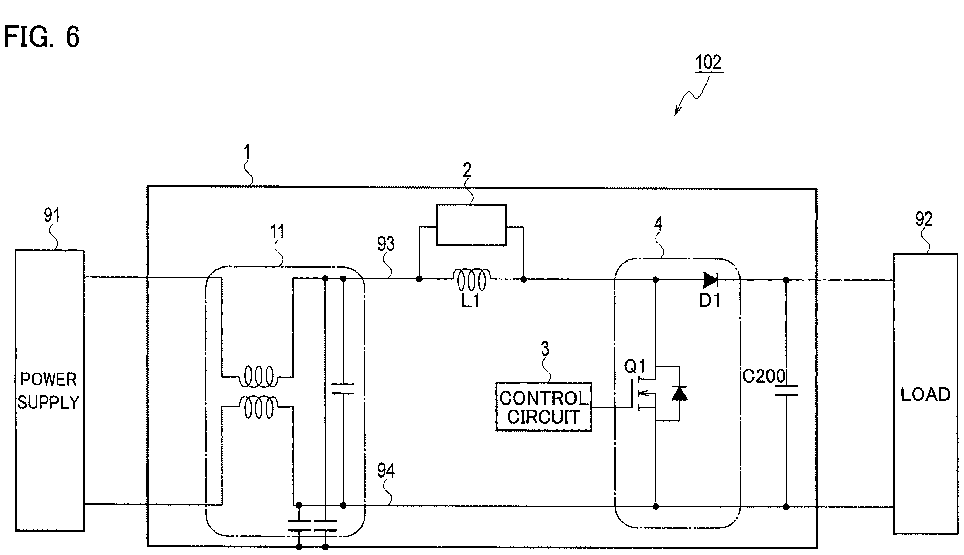

Next, a second embodiment of the present invention is described. Fig. 6 is a circuit diagram illustrating a configuration of a power conversion device and peripheral devices thereof according to the second embodiment of the present invention. As illustrated in Fig. 6, a power conversion device 102 according to the second embodiment is different from that of the first embodiment described above in that a filter circuit 11 (a low-pass filter) is provided on the upstream side of the reactor L1. Other configurations are identical to those in Fig. 1, therefore are denoted by like reference signs and configurational explanations thereof are omitted.

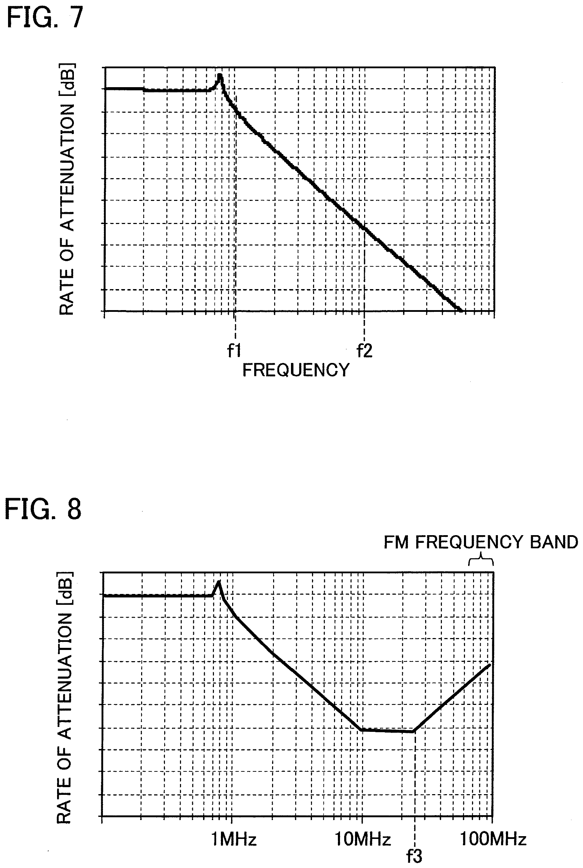

The filter circuit 11 is an LC low-pass filter, and includes a choke coil and three capacitors. The configuration of the filter circuit 11 is not limited thereto, and another configuration can be employed. The filter circuit 11 has attenuation characteristics illustrated in Fig. 7, and its cutoff frequency at which a gain is attenuated by 3 dB is denoted by f1. Further, a frequency at which removal of noise is desired is represented as a stop frequency f2.

An electrostatic capacitance of the capacitance element C2 is set in such a manner that the first resonance frequency fr1 expressed by the expression (3) described above is larger than the cutoff frequency f1 of the filter circuit 11. Therefore, noise generated by the first resonance frequency fr1 can be reduced by the filter circuit 11.

Further, by setting the electrostatic capacitance of the capacitance element C2 in such a manner that the first resonance frequency fr1 is higher than the stop frequency f2, noise can be reduced more effectively. The stop frequency f2 is set to a fundamental frequency when the switching element Q1 is switched, or a low-order harmonic frequency, for example.

In addition, in a case of actually configuring the filter circuit 11, there is a frequency at which failure of attenuation characteristics of the filter circuit 11 occurs because of an influence of a parasitic capacitance or a parasitic inductance of each part constituting the filter circuit 11. Specifically, failure of attenuation characteristics is caused by an equivalent series inductance of a capacitor constituting the filter circuit 11 or an equivalent capacitance that is parasitic between windings of the choke coil.

As a result, although the filter circuit ideally has characteristics in which, when a frequency exceeds the cutoff frequency f1, attenuation characteristics decrease as the frequency becomes higher, as illustrated in Fig. 7, it actually has characteristics in which, when a frequency exceeds a frequency f3, attenuation characteristics increase as the frequency becomes higher, as illustrated in Fig. 8, for the reason described above. Therefore, noise in a frequency band higher than the frequency f3 cannot be removed. For example, in a case where the frequency f3 is lower than a range from 76 [MHz] to 108 [MHz] that is a frequency modulation radio band (a radio FM frequency band), noise in this FM frequency band cannot be reduced.

In the present embodiment, an electrostatic capacitance of the capacitance element C2 is set in such a manner that the first resonance frequency fr1 described above is lower than the frequency f3. That is, the electrostatic capacitance of the capacitance element C2 is set in such a manner that the first resonance frequency fr1 is lower than the frequency f3 at which the rate of attenuation by the filter circuit 11 (the low-pass filter) starts to rise. By this setting, it is possible to prevent generation of noise in a radio FM frequency band, even in a case where attenuation characteristics are increased at the frequency f3. That is, it is possible to cancel out a noise current flowing through the first power feed bus 93 and the second power feed bus 94 and reduce noise generated in the metal housing 1 in a frequency band such as a radio FM frequency band.

In this manner, in the power conversion device 102 according to the second embodiment, by providing the filter circuit 11 (the low-pass filter), it is possible to reduce noise generated due to existence of the first resonance frequency fr1 by an inductance of the reactor L1 and an electrostatic capacitance of the capacitance element C2. Therefore, noise generated by switching of the switching element Q1 can be reduced.

Further, by setting the first resonance frequency fr1 to be higher than the cutoff frequency f1 of the filter circuit 11, noise generated due to existence of the first resonance frequency fr1 can be more effectively removed in the filter circuit 11, so that noise generated by switching of the switching element Q1 can be reduced.

Further, by setting the first resonance frequency fr1 to be lower than the frequency f3 (see Fig. 8) at which failure of attenuation characteristics of the filter circuit 11 occurs, noise generated due to existence of the first resonance frequency fr1 can be more effectively removed in the filter circuit 11, so that noise generated by switching of the switching element Q1 can be reduced.

[Descriptions of third embodiment]

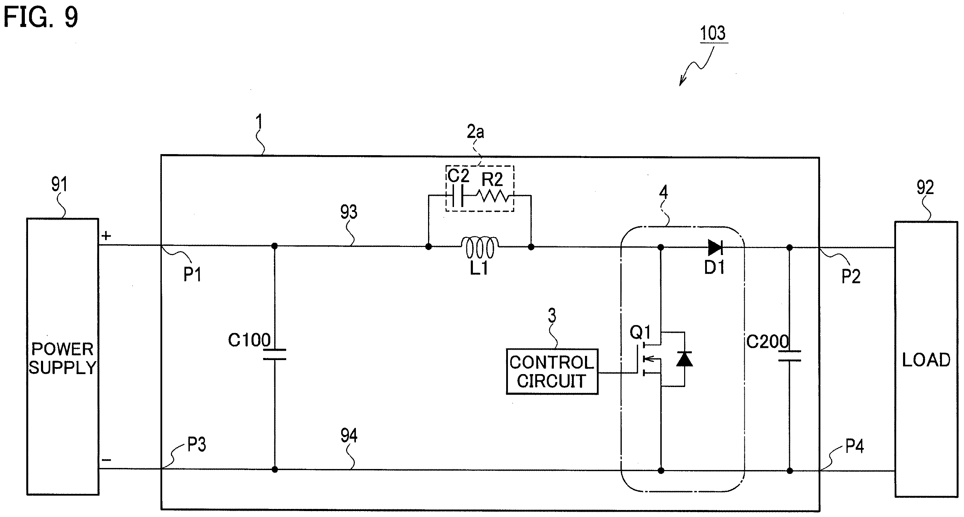

Next, a third embodiment of the present invention is described. Fig. 9 is a circuit diagram illustrating a configuration of a power conversion device and peripheral devices thereof according to the third embodiment of the present invention. A power conversion device 103 according to the third embodiment is different from that of the first embodiment described above in that a series-connected circuit formed by a capacitance element C2 and a resistance element R2 is provided within an impedance circuit 2a. Other configurations are identical to those in Fig. 1, therefore are denoted by like reference signs and configurational explanations thereof are omitted.

A resistance value of the resistance element R2 is set to be smaller than a resistance value of the second power feed bus (a resistance value between the points P3 and P4).

Further, in a frequency band in which an electrostatic capacitance of the capacitance element C2 is smaller than an impedance of the second power feed bus 94, high-frequency noise energy flowing to the impedance circuit 2a is consumed as heat by the resistance element R2 due to existence of the resistance element R2. Therefore, high-frequency noise energy generated in the metal housing 1 can be absorbed.

[Descriptions of fourth embodiment]

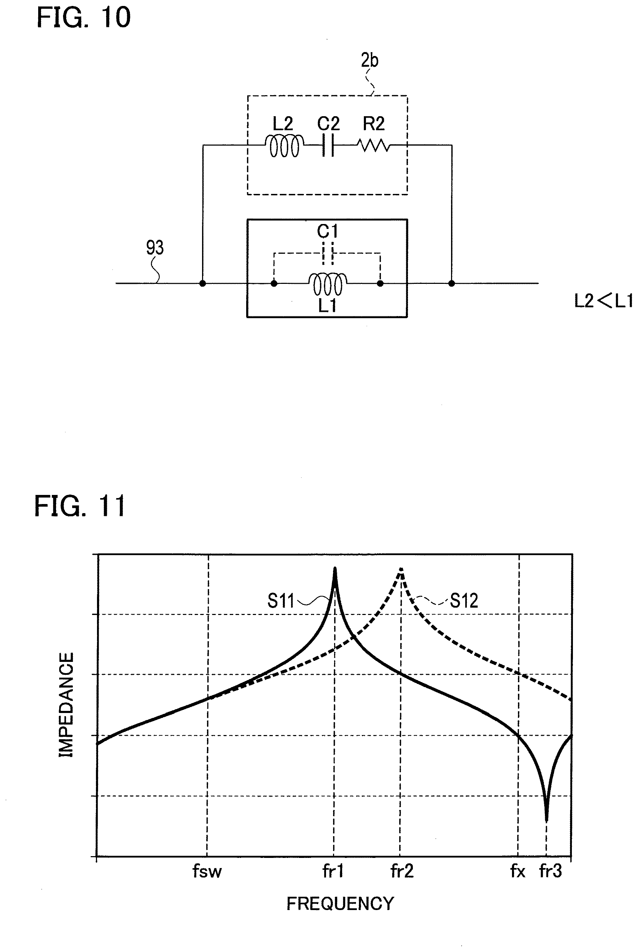

Next, a fourth embodiment of the present invention is described. Fig. 10 is a diagram illustrating an impedance circuit according to the fourth embodiment of the present invention. The fourth embodiment is different from the first embodiment described above in that a series-connected circuit formed by the capacitance element C2, the resistance element R2, and an inductance element L2 is provided within an impedance circuit 2b. Other configurations are identical to the circuit illustrated in Fig. 1.

A resistance value of the resistance element R2 is set to be smaller than a resistance value of the second power feed bus 94 (the resistance value between the points P3 and P4 in Fig. 1). Further, an inductance of the inductance element L2 is set to be smaller than an inductance of the reactor L1.

Fig. 11 is a graph representing a change of impedance of the reactor L1 and the impedance circuit 2b in Fig. 10. In Fig. 11, the horizontal axis represents a frequency and the vertical axis represents an impedance. Further, a curve S11 illustrated with a solid line represents characteristics in a case where the impedance circuit 2b is provided, and a curve S12 illustrated with a dotted line represents characteristics in a case where the impedance circuit 2b is not provided.

The frequency fr1 illustrated in Fig. 11 is the first resonance frequency in a case where the impedance circuit 2b is provided, and the frequency fr2 is a resonance frequency in a case where the impedance circuit 2b is not provided. Further, a frequency fr3 is a second resonance frequency of the impedance circuit 2b. The second resonance frequency fr3 can be expressed by the following expression (5).

[Equation 2]

$$fr3 = \frac{1}{2\pi\sqrt{L2 \cdot C2}} \quad \cdots \ (5)$$

In the fourth embodiment, the second resonance frequency fr3 exists because the inductance element L2 is provided in the impedance circuit 2b. By setting the second resonance frequency fr3 to a higher frequency than a desired frequency, it is possible to reduce an impedance at the desired frequency, cancel out a noise current generated by switching, and reduce high-frequency noise energy generated in the metal housing 1.

For example, in Fig. 11, the second resonance frequency fr3 is set to be higher than a frequency fx in a radio FM frequency band in which removal of noise is desired. At the frequency fx, it is possible to reduce an impedance caused by the reactor L1 and to make an impedance of the first power feed bus 93 closer to an impedance of the second power feed bus 94. As a result, a noise current generated by switching of the switching element Q1 can be canceled out, and high-frequency noise energy generated in the metal housing 1 can be reduced. Therefore, it is possible to prevent a frequency in a radio FM frequency band or the like from being influenced.

In this manner, in the fourth embodiment, a series-connected circuit formed by the capacitance element C2, the resistance element R2, and the inductance element L2 is provided in the impedance circuit 2b. Further, the second resonance frequency fr3 is set to be higher than the predetermined frequency fx (threshold frequency) that is set in advance. Accordingly, the impedance of the first power feed bus 93 can be reduced, and noise generated by switching can be reduced at the frequency fx.

Further, by setting the frequency fx (threshold frequency) to a maximum frequency of a radio FM frequency band, the impedance of the first power feed bus 93 can be reduced in the radio frequency band, and noise generated by switching and flowing to the metal housing 1 can be reduced.

[Descriptions of fifth embodiment]

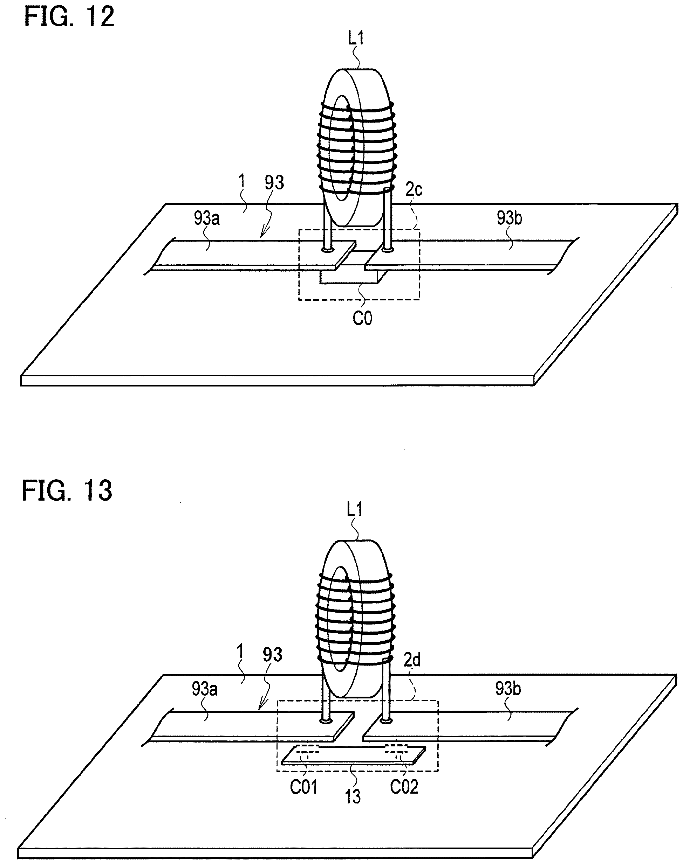

Next, a fifth embodiment of the present invention is described. Fig. 12 is an explanatory diagram schematically illustrating a configuration of the reactor L1 and an impedance circuit 2c used in a power conversion device according to the fifth embodiment of the present invention. As illustrated in Fig. 12, the first power feed bus 93 is divided into two buses 93a and 93b, and the reactor L1 is provided to straddle the buses 93a and 93b. The first power feed bus 93 is formed by a flat metal plate.

A discrete capacitance element C0 is provided between the two buses 93a and 93b. More specifically, the capacitance element C0 for connecting each of the buses 93a and 93b is provided on a surface of each of the two buses 93a and 93b having a flat shape, which is opposite to a surface on which the reactor L1 is attached.

The fifth embodiment is different from the first embodiment described above in that a capacitance element provided in the impedance circuit 2c is the discrete capacitance element C0. By using the discrete capacitance element C0, the capacitance element C0 can be easily attached to the first power feed bus 93.

Further, the resistance element R2 (see Fig. 9) described in the third embodiment described above and the inductance element L2 (see Fig. 10) described in the fourth embodiment can be also formed by discrete elements.

In this manner, the impedance circuit 2c is formed by a discrete part in the fifth embodiment, thereby simplifying the configuration.

[Descriptions of sixth embodiment]

Next, a sixth embodiment of the present invention is described. Fig. 13 is an explanatory diagram schematically illustrating a configuration of the reactor L1 and an impedance circuit 2d used in a power conversion device according to the sixth embodiment of the present invention. As illustrated in Fig. 13, the first power feed bus 93 is divided into two buses 93a and 93b, and the reactor L1 is provided to straddle the buses 93a and 93b. The first power feed bus 93 is formed by a flat metal plate.

A flat conductive member 13 is provided at a position away from the two buses 93a and 93b by a predetermined distance. More specifically, the flat conductive member 13 is capacitively coupled to a surface of each of the two buses 93a and 93b having a flat shape, which is opposite to a surface on which the reactor L1 is attached, to be opposed to the respective buses 93a and 93b.

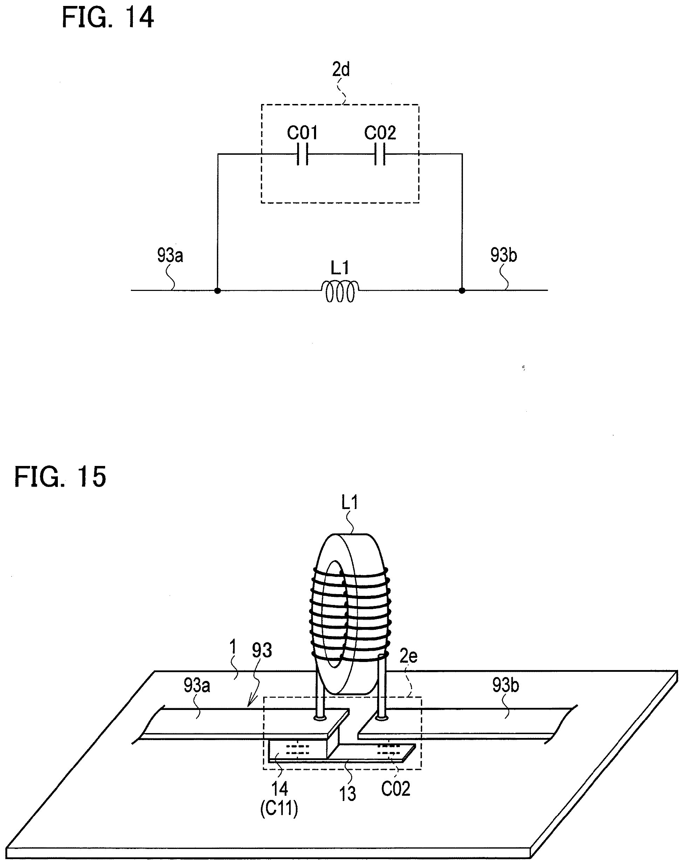

Therefore, electrostatic capacitances C01 and C02 exist between the respective buses 93a and 93b and the conductive member 13. Accordingly, as illustrated in an equivalent circuit of Fig. 14, the electrostatic capacitances C01 and C02 exist in parallel with respect to the reactor L1.

Here, the electrostatic capacitance C2 of the impedance circuit 2d is a combined capacitance of the two electrostatic capacitances C01 and C02 connected in series, and therefore can be expressed by the following expression (6).

$$C2=(C01 \cdot C02)/(C01+C02) \quad \cdots(6).$$

In this manner, in the present embodiment, the impedance circuit 2d is constituted by the conductive member 13 that is arranged to straddle the two buses 93a and 93b and is capacitively coupled to each of the buses 93a and 93b. Therefore, an electrostatic capacitance of the impedance circuit 2d can be constituted by the electrostatic capacitances C01 and C02 between the respective buses 93a and 93b and the conductive member 13. Accordingly, the configuration of the impedance circuit 2d can be simplified.

[Descriptions of first modification of sixth embodiment]

Next, a first modification of the sixth embodiment is described. Fig. 15 is an explanatory diagram schematically illustrating a configuration of the reactor L1 and an impedance circuit 2e used in a power conversion device according to the first modification of the sixth embodiment. As illustrated in Fig. 15, the first power feed bus 93 is divided into two buses 93a and 93b, and the reactor L1 is provided to straddle the buses 93a and 93b. Each of the buses 93a and 93b is formed by a flat metal plate.

Further, the flat conductive member 13 is provided to be opposed to the two buses 93a and 93b. A dielectric body 14 is provided between the conductive member 13 and the bus 93a. In general, it is known that an electrostatic capacitance of a capacitance element is expressed by the following expression (7).

$$(\text{Electrostatic capacitance}) = \varepsilon0 \cdot \varepsilon r \cdot (S/d) \quad \cdots(7)$$

where ε0 is a permittivity of vacuum, εr is a relative permittivity, S is an opposed area, and d is a distance.

Therefore, the relative permittivity sr can be made larger by providing the dielectric body 14 between the bus 93a and the conductive member 13, so that the electrostatic resistance can be increased.

As a result, it is possible to reduce an impedance caused by the reactor L1 and to make an impedance of the first power feed bus 93 closer to an impedance of the second power feed bus 94. Therefore, it is possible to cancel out a noise current generated by switching of the switching element Q1 and to reduce high-frequency noise energy generated in the metal housing 1. It is permissible to provide the dielectric body 14 between the bus 93b and the conductive member 13.

[Descriptions of second modification of sixth embodiment]

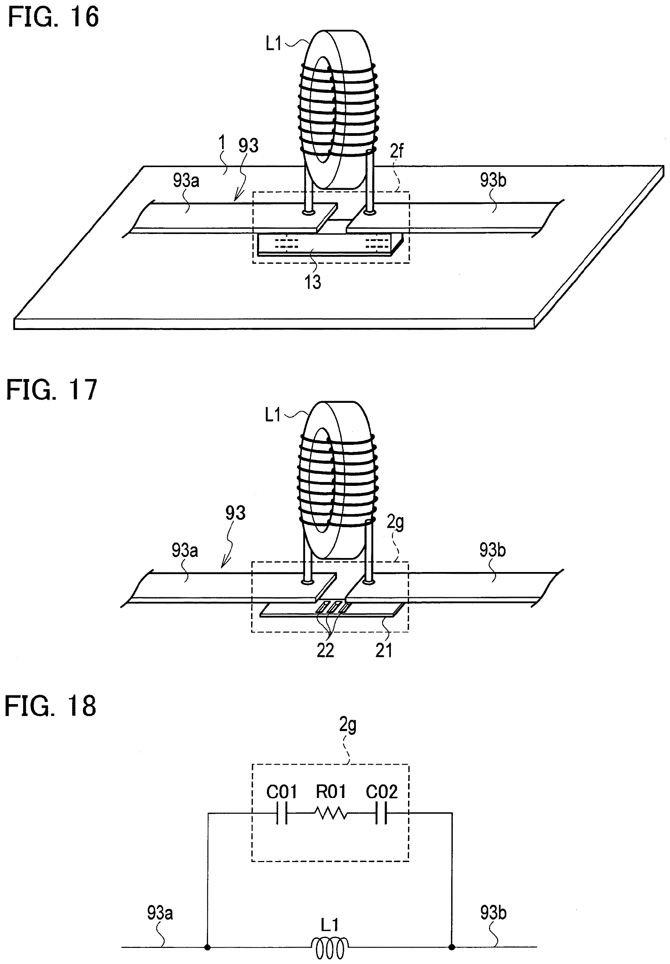

Next, a second modification of the sixth embodiment is described. Fig. 16 is an explanatory diagram schematically illustrating a configuration of the reactor L1 and an impedance circuit 2f used in a power conversion device according to the second modification of the sixth embodiment. As illustrated in Fig. 16, the second modification is different from the first modification described above in that the dielectric body 14 is provided between the conductive member 13 and the two buses 93a and 93b.

Also with this configuration, both an electrostatic capacitance between the bus 93a and the conductive member 13 and an electrostatic capacitance between the bus 93b and the conductive member 13 can be made larger. Therefore, it is possible to make an electrostatic capacitance of the impedance circuit 2f larger, similarly to the first modification. Further, as compared with the first modification, because the two electrostatic capacitances can be made larger, an entire electrostatic capacitance can be made larger easily.

[Descriptions of seventh embodiment]

Next, a seventh embodiment of the present invention is described. Fig. 17 is an explanatory diagram schematically illustrating a configuration of the reactor L1 and an impedance circuit 2g used in a power conversion device according to the seventh embodiment of the present invention. As illustrated in Fig. 17, the first power feed bus 93 is divided into two buses 93a and 93b, and the reactor L1 is provided to straddle the buses 93a and 93b. The first power feed bus 93 is formed by a flat metal plate.

A flat conductive member 21 is provided at a position away from the two buses 93a and 93b by a predetermined distance. More specifically, the flat conductive member 21 is capacitively coupled to a surface of each of the buses 93a and 93b having a flat shape, which is opposite to a surface on which the reactor L1 is attached, to be opposed to the two buses 93a and 93b.

Further, the conductive member 21 has slits 22 extending therethrough at three locations. That is, the slit 22 serves as a portion that can change a cross-sectional area where a resistance component is formed. Although the slits 22 are formed at three locations in Fig. 17, the number of slits is not limited to three. The resistance value of the conductive member 21 is increased by the slit 22.

Therefore, as illustrated in an equivalent circuit of Fig. 18, the impedance circuit 2g is a series-connected circuit formed by the two electrostatic capacitances C01 and C02 and a resistance component R01.

With this configuration, an RC series circuit can be formed within the impedance circuit 2g so that an impedance caused by the reactor L1 can be made smaller. Accordingly, it is possible to make an impedance of the first power fed bus 93 closer to an impedance of the second power feed bus 94, cancel out a noise current generated by switching, and reduce high-frequency noise energy generated in the metal housing 1.

Further, the number or a cross-sectional area of the slits 22 can be adjusted to change a resistance value, thereby facilitating setting of the resistance value.

[Other embodiments]

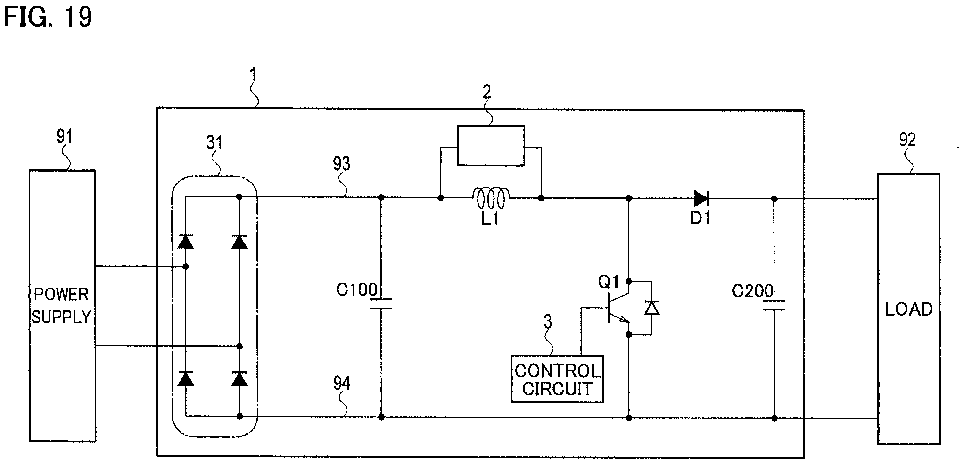

In each of the embodiments described above, an example has been described in which power is converted by using the power module 4 formed by the switching element Q1 and the diode D1, as illustrated in Fig. 1. However, the present invention is not limited to the embodiments. For example, a rectifier circuit 31 formed by a diode-bridge circuit can be provided at a preceding stage of the smoothing capacitor C100, as illustrated in Fig. 19. In this case, when power supplied from the power supply 91 is an alternating current, it is possible to rectify this alternating current to be supplied to the power module 4.

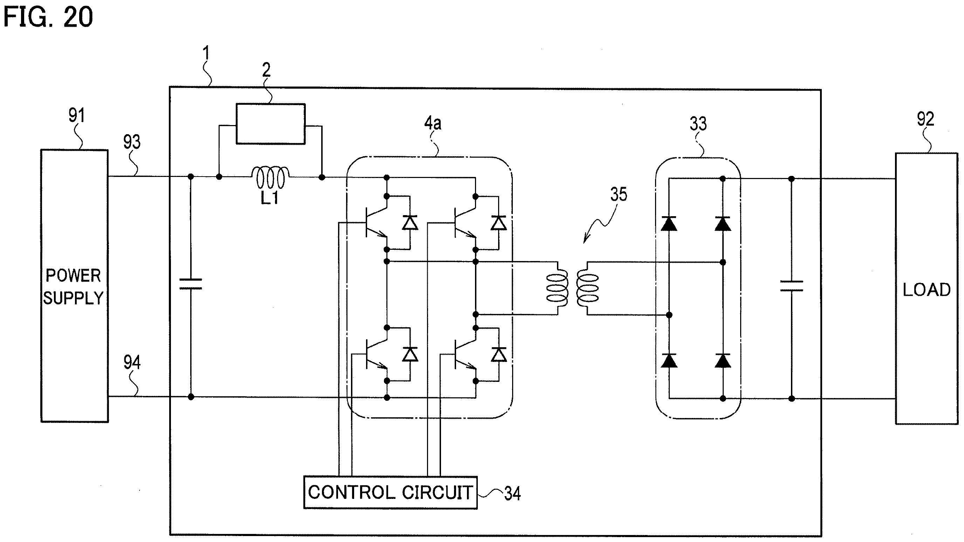

Further, a power conversion device can be configured to include a power module 4a including four switching elements, a control circuit 34 that controls the power module 4a, a transformer 35, and a rectifier circuit 33 including four diodes at a subsequent stage of the reactor L1, as illustrated in Fig. 20. Also with this configuration, noise can be reduced by providing the impedance circuit 2 with respect to the reactor L1 provided between the power supply 91 and the power module 4a.

Although the power conversion device according to the present invention has been described above based on the embodiments as illustrated in the drawings, the present invention can be replaced by configurations having identical functions thereto.

REFERENCE SIGNS LIST

| | |
|---|---|
| 1 | metal housing |
| 2, 2a, 2b, 2c, 2d, 2e, 2f, 2g | impedance circuit |
| 3, 34 | control circuit |
| 4, 4a | power module |
| 11 | filter circuit |
| 13 | conductive member |
| 14 | dielectric body |
| 21 | conductive member |
| 22 | slit |
| 31,33 | rectifier circuit |
| 35 | transformer |
| 91 | power supply |
| 92 | load |

| 93 | first power feed bus |
| 93a | bus |
| 93b | bus |
| 94 | second power feed bus |
| 101, 102, 103 | power conversion device |
| C100, C200 | smoothing capacitor |
| D1 | diode |
| Q1 | switching element |
| R2 | resistance element |

## Claims

1. A power conversion device (101; 102; 103) that converts power supplied by a pair of power feed buses, the power conversion device (101; 102; 103) comprising:

   a reactor (L1) connected to one of the pair of power feed buses; and
   a switching element (Q1) that converts power supplied to the pair of power feed buses by switching;
   the pair of power feed buses including a first power feed bus (93) and a second power feed bus (94), and
   an impedance circuit (2) arranged in parallel with respect to the reactor (L1),
   **characterized in that**:
   an impedance of the impedance circuit (2) is set in such a manner that an impedance caused by the reactor (L1) is reduced and an impedance value of the first power feed bus (93) is made close to an impedance value of the second power feed bus (94).

2. The power conversion device (101; 102; 103) according to claim 1, wherein
   the impedance circuit (2) includes a capacitance element (C2).

3. The power conversion device (101; 102; 103) according to claim 2, wherein
   an electrostatic capacitance value of the capacitance element (C2) is larger than an electrostatic capacitance value of a parasitic capacitance (C1) included in the reactor (L1).

4. The power conversion device (101; 102; 103) according to claim 2 or 3, wherein
   a first resonance frequency by an electrostatic capacitance of the capacitance element (C2) and an inductance of the reactor (L1) is higher than a switching frequency of the switching element (Q1).

5. The power conversion device (102) according to any one of claims 2 to 4, further comprising a low-pass filter (11) connected between the pair of power feed buses on an upstream side of the reactor (L1), wherein
   a first resonance frequency by an inductance of the reactor (L1) and an electrostatic capacitance of the capacitance element (C2) is higher than a cutoff frequency of the low-pass filter (11).

6. The power conversion device (102) according to claim 5, wherein
   the first resonance frequency is higher than a stop frequency of the low-pass filter (11).

7. The power conversion device (102) according to claim 5 or 6, wherein
   the first resonance frequency is lower than a frequency at which a rate of attenuation by the low-pass filter (11) starts to rise.

8. The power conversion device (103) according to any one of claims 1 to 7, wherein

   the reactor (L1) is connected to the first power feed bus (93),
   the impedance circuit (2) includes a resistance element (R2), and
   a resistance value of the resistance element (R2) is smaller than a resistance value of the second power feed bus (94) which the impedance circuit (2) is not connected to.

9. The power conversion device (101; 102; 103) according to any one of claims 2 to 7, wherein

   the impedance circuit (2) includes an inductance element (L2) in addition to the capacitance element (C2), and

a second resonance frequency by an electrostatic capacitance of the capacitance element (C2) and an inductance of the inductance element (L2) is higher than a preset threshold frequency.

10. The power conversion device (101; 102; 103) according to claim 9, wherein
the threshold frequency is a maximum frequency of a frequency modulation radio band.

11. The power conversion device (101; 102; 103) according to any one of claims 1 to 10, wherein
the impedance circuit (2c) is constituted by discrete parts.

12. The power conversion device (101; 102; 103) according to any one of claims 1 to 11, wherein

the reactor (L1) is connected to the first power feed bus (93), and
the impedance circuit (2) is a conductive member (13, 21) that is capacitively coupled to the pair of power feed buses and that is provided away from the first power feed bus (93) which the impedance circuit (2) is connected to.

13. The power conversion device (101; 102; 103) according to claim 12, wherein
a dielectric body (14) is provided between the first power feed bus (93) and the conductive member (13, 21).

14. The power conversion device (101; 102; 103) according to claim 13, wherein
the dielectric body (14) is provided only between the first power feed bus (93) connected to one of terminals of the reactor (L1), and the conductive member (13, 21).

15. The power conversion device (101; 102; 103) according to any one of claims 12 to 14, wherein

the conductive member (21) has a flat shape, and
a portion (22) capable of changing a cross-sectional area of the conductive member (21) is formed in the conductive member (21) to form a resistance component.


**Patentansprüche**

1. Stromumwandlungsvorrichtung (101; 102; 103), die den von einem Paar von Stromzuführungsleitungen zugeführten Strom umwandelt, wobei die Stromumwandlungsvorrichtung (101; 102; 103) umfasst:

eine Drossel (L1), die mit einer des Paars von Stromzuführungsleitungen verbunden ist; und
ein Schaltelement (Q1), das den dem Paar von Stromzuführungsleitungen zugeführten Strom durch Schalten umwandelt;
wobei das Paar von Stromzuführungsleitungen eine erste Stromzuführungsleitung (93) und eine zweite Stromzuführungsleitung (94) umfasst, und
eine Impedanzschaltung (2), die in Bezug auf die Drossel (L1) parallel angeordnet ist,
**dadurch gekennzeichnet, dass**:
eine Impedanz der Impedanzschaltung (2) so eingestellt ist, dass sich eine durch die Drossel (L1) verursachte Impedanz reduziert und ein Impedanzwert der ersten Stromzuführungsleitung (93) in die Nähe eines Impedanzwerts der zweiten Stromzuführungsleitung (94) gebracht wird

2. Stromumwandlungsvorrichtung (101, 102; 103) nach Anspruch 1, wobei
die Impedanzschaltung (2) ein kapazitives Element (C2) umfasst.

3. Stromumwandlungsvorrichtung (101; 102; 103) nach Anspruch 2, wobei ein elektrostatischer Kapazitätswert des Kapazitätselements (C2) größer als ein elektrostatischer Kapazitätswert einer in der Drossel (L1) enthaltenen parasitären Kapazität (C1) ist.

4. Stromumwandlungsvorrichtung (101; 102; 103) nach Anspruch 2 oder 3, wobei
eine erste Resonanzfrequenz durch eine elektrostatische Kapazität des Kapazitätselements (C2) und eine Induktivität der Drossel (L1) höher als eine Schaltfrequenz des Schaltelements (Q1) ist.

5. Stromumwandlungsvorrichtung (102) nach einem der Ansprüche 2 bis 4, ferner umfassend einen Tiefpassfilter (11), der zwischen dem Paar von Stromzuführungsleitungen auf einer stromaufwärtigen Seite der Drossel (L1) angeschlossen ist, wobei

eine erste Resonanzfrequenz durch eine Induktivität der Drossel (L1) und eine elektrostatische Kapazität des Kapazitätselements (C2) höher als eine Grenzfrequenz des Tiefpassfilters (11) ist.

6. Stromumwandlungsvorrichtung (102) nach Anspruch 5, wobei
die erste Resonanzfrequenz höher als eine Sperrfrequenz des Tiefpassfilters (11) ist.

7. Stromumwandlungsvorrichtung (102) nach Anspruch 5 oder 6, wobei
die erste Resonanzfrequenz niedriger als eine Frequenz ist, bei der eine Dämpfungsrate durch das Tiefpassfilter (11) anzusteigen beginnt.

8. Stromumwandlungsvorrichtung (103) nach einem der Ansprüche 1 bis 7, wobei
die Drossel (L1) mit der ersten Stromversorgungsleitung (93) verbunden ist,
die Impedanzschaltung (2) ein Widerstandselement (R2) umfasst, und
ein Widerstandswert des Widerstandselements (R2) kleiner als ein Widerstandswert der zweiten Stromversorgungsleitung (94) ist, an der die Impedanzschaltung (2) nicht angeschlossen ist.

9. Stromumwandlungsvorrichtung (101; 102; 103) nach einem der Ansprüche 2 bis 7,
wobei die Impedanzschaltung (2) zusätzlich zum Kapazitätselement (C2) ein Induktivitätselement (L2) umfasst, und
eine zweite Resonanzfrequenz durch eine elektrostatische Kapazität des Kapazitätselements (C2) und eine Induktivität des Induktivitätselements (L2) höher als eine voreingestellte Schwellenfrequenz ist.

10. Stromumwandlungsvorrichtung (101; 102; 103) nach Anspruch 9,
wobei die Schwellenfrequenz eine maximale Frequenz eines Frequenzmodulationsfunkbandes ist.

11. Stromumwandlungsvorrichtung (101; 102; 103) nach einem der Ansprüche 1 bis 10, wobei
die Impedanzschaltung (2c) aus diskreten Teilen aufgebaut ist.

12. Stromumwandlungseinrichtung (101; 102; 103) nach einem der Ansprüche 1 bis 11, wobei
die Drossel (L1) mit der ersten Stromzuführungsleitung (93) verbunden ist, und
die Impedanzschaltung (2) ein leitendes Element (13, 21) ist, das mit dem Paar von Stromzuführungsleitungen kapazitiv verbunden ist und das entfernt von der ersten Stromzuführungsleitung (93) vorgesehen ist, an der die Impedanzschaltung (2) angeschlossen ist.

13. Stromumwandlungsvorrichtung (101; 102; 103) nach Anspruch 12, wobei
ein dielektrischer Körper (14) zwischen der ersten Stromzuführungsleitung (93) und dem leitenden Element (13, 21) vorgesehen ist.

14. Stromumwandlungsvorrichtung (101; 102; 103) nach Anspruch 13, wobei
der dielektrische Körper (14) nur zwischen der ersten Stromzuführungsleitung (93), die mit einem der Anschlüsse der Drossel (L1) verbunden ist, und dem leitenden Element (13, 21) vorgesehen ist.

15. Stromumwandlungsvorrichtung (101; 102; 103) nach einem der Ansprüche 12 bis 14, wobei
das leitende Element (21) eine ebene-Form aufweist, und
ein Abschnitt (22), der zum Verändern einer Querschnittsfläche des leitenden Elements (21) imstande ist, im leitenden Element (21) ausgebildet ist, um eine Widerstandskomponente zu bilden.

**Revendications**

1. Dispositif de conversion de puissance (101 ; 102 ; 103) qui convertit la puissance fournie par une paire de bus d'alimentation électrique, le dispositif de conversion de puissance (101 ; 102 ; 103) comprenant :

un réacteur (L1) relié à l'un de la paire de bus d'alimentation électrique ; et
un élément de commutation (Q1) qui convertit la puissance fournie à la paire de bus d'alimentation électrique par commutation ;
la paire de bus d'alimentation électrique comportant un premier bus d'alimentation électrique (93) et un deuxième bus d'alimentation électrique (94), et

un circuit d'impédance (2) agencé en parallèle par rapport au réacteur (L1),

**caractérisé en ce que** :

une impédance du circuit d'impédance (2) est définie de manière à ce qu'une impédance provoquée par le réacteur (L1) soit réduite et qu'une valeur d'impédance du premier bus d'alimentation électrique (93) soit rendue proche d'une valeur d'impédance du deuxième bus d'alimentation électrique (94).

2. Dispositif de conversion de puissance (101 ; 102; 103) selon la revendication 1, dans lequel
le circuit d'impédance (2) comporte un élément capacitif (C2).

3. Dispositif de conversion de puissance (101 ; 102; 103) selon la revendication 2, dans lequel
une valeur de capacité électrostatique de l'élément capacitif (C2) est supérieure à une valeur de capacité électrostatique d'une capacité parasite (C1) incluse dans le réacteur (L1).

4. Dispositif de conversion de puissance (101 ; 102; 103) selon la revendication 2 ou 3, dans lequel
une première fréquence de résonance par une capacité électrostatique de l'élément capacitif (C2) et une inductance du réacteur (L1) est supérieure à une fréquence de commutation de l'élément de commutation (Q1).

5. Dispositif de conversion de puissance (102) selon l'une quelconque des revendications 2 à 4, comprenant en outre un filtre passe-bas (11) relié entre la paire de bus d'alimentation électrique sur un côté amont du réacteur (L1), dans lequel
une première fréquence de résonance par une inductance du réacteur (L1) et une capacité électrostatique de l'élément capacitif (C2) est supérieure à une fréquence de coupure du filtre passe-bas (11).

6. Dispositif de conversion de puissance (102) selon la revendication 5, dans lequel
la première fréquence de résonance est supérieure à une fréquence d'arrêt du filtre passe-bas (11).

7. Dispositif de conversion de puissance (102) selon la revendication 5 ou 6, dans lequel
la première fréquence de résonance est inférieure à une fréquence à laquelle un taux d'atténuation par le filtre passe-bas (11) commence à augmenter.

8. Dispositif de conversion de puissance (103) selon l'une quelconque des revendications 1 à 7, dans lequel
le réacteur (L1) est relié au premier bus d'alimentation électrique (93),
le circuit d'impédance (2) comporte un élément de résistance (R2), et une valeur de résistance de l'élément de résistance (R2) est inférieure à une valeur de résistance du deuxième bus d'alimentation électrique (94) auquel le circuit d'impédance (2) n'est pas relié.

9. Dispositif de conversion de puissance (101 ; 102 ; 103) selon l'une quelconque des revendications 2 à 7, dans lequel
le circuit d'impédance (2) comporte un élément d'inductance (L2) en plus de l'élément capacitif (C2), et
une deuxième fréquence de résonance par une capacité électrostatique de l'élément capacitif (C2) et une inductance de l'élément d'inductance (L2) est supérieure à une fréquence seuil prédéfinie.

10. Dispositif de conversion de puissance (101 ; 102; 103) selon la revendication 9, dans lequel
la fréquence seuil est une fréquence maximale d'une bande radio de modulation de fréquence.

11. Dispositif de conversion de puissance (101 ; 102 ; 103) selon l'une quelconque des revendications 1 à 10, dans lequel
le circuit d'impédance (2c) est constitué de parties discrètes.

12. Dispositif de conversion de puissance (101 ; 102 ; 103) selon l'une quelconque des revendications 1 à 11, dans lequel
le réacteur (L1) est relié au premier bus d'alimentation électrique (93), et
le circuit d'impédance (2) est un élément conducteur (13, 21) qui est couplé de manière capacitive à la paire de bus d'alimentation électrique et qui est prévu loin du premier bus d'alimentation électrique (93) auquel le circuit d'impédance (2) est relié.

13. Dispositif de conversion de puissance (101 ; 102; 103) selon la revendication 12, dans lequel
un corps diélectrique (14) est prévu entre le premier bus d'alimentation électrique (93) et l'élément conducteur (13, 21).

14. Dispositif de conversion de puissance (101 ; 102; 103) selon la revendication 13, dans lequel

le corps diélectrique (14) est prévu uniquement entre le premier bus d'alimentation électrique (93) relié à l'une des bornes du réacteur (L1), et l'élément conducteur (13, 21).

15. Dispositif de conversion de puissance (101 ; 102 ; 103) selon l'une quelconque des revendications 12 à 14, dans lequel
l'élément conducteur (21) a une forme plate, et
une partie (22) capable de changer une zone de section transversale de l'élément conducteur (21) est formée dans l'élément conducteur (21) pour former un composant de résistance.

## FIG. 1

EP 3 468 020 B1

FIG. 2

FIG. 3

FIG. 4

FIG. 5

FIG. 6

FIG. 7

FIG. 8

FIG. 9

FIG. 10

L2＜L1

FIG. 11

EP 3 468 020 B1

FIG. 12

L1

1  93
93a        2c        93b

C0

FIG. 13

L1

1  93
93a        2d        93b

C01   13   C02

22

FIG. 14

FIG. 15

## FIG. 16

## FIG. 17

## FIG. 18

# FIG. 19

EP 3 468 020 B1

## FIG. 20

EP 3 468 020 B1

**EP 3 468 020 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1610450 A2
- JP H11341787 B